# FASCICULE DE BREVET EUROPEEN

(11) **EP 1 158 679 B1**
(45) Date de publication et mention de la délivrance du brevet: **31.08.2005**
(21) Numéro de dépôt: 01401262.9
(22) Date de dépôt: 16.05.2001
(51) Int. Cl.: H03L 7/081, H03B 27/00, H03H 11/22

(54) **Procédé et dispositif de contrôle du déphasage entre quatre signaux mutuellement en quadrature de phase**
Verfahren und Anordnung zur Steuerung der Phase von vier Signalen wechselseitig in Quadratur
Method and device for controlling the phase shift of four signals mutually in phase quadrature

(30) Priorité: 19.05.2000 FR 0006468
(43) Date de publication de la demande: 28.11.2001
(73) Titulaire: STMicroelectronics S.A., 92120 Montrouge (FR)
(72) Inventeur: Dedieu, Sébastien, 38400 St. Martin d'Hères (FR); Paillardet, Frédéric, 73100 Aix-les-Bains (FR); Telliez, Isabelle, Berkeley, CA 94704-1204 (US)
(74) Mandataire: Casalonga, Axel

(56) Documents cités:
- FR-A- 2 670 975
- US-A- 5 060 298
- US-A- 5 455 543
- US-A- 5 898 913

## Description

L'invention concerne le contrôle du déphasage entre quatre signaux mutuellement en quadrature de phase. Elle s'applique avantageusement mais non limitativement à la télédiffusion numérique par satellite telle que définie dans la spécification européenne DVB-S (Digital Video Broadcasting-Satellite) basée sur les normes de compression M-PEG, et utilisant par exemple pour véhiculer les informations, une modulation numérique en quadrature, par exemple une modulation sur un grand nombre de porteuses orthogonales (modulation OFDM : "Orthogonal Frequency Division Multiplexing").

L'invention s'applique ainsi plus particulièrement aux synthonisateurs ("Tuner" en langue anglaise), en particulier du type à fréquence intermédiaire nulle, tel que par exemple ceux incorporés dans les récepteurs-satellite avec décodeur de données d'images comprimées ("Set-top box" en langue anglaise).

Les signaux de télévision en provenance d'un satellite sont amplifiés et convertis dans une bande de fréquences prédéterminée (typiquement 950-2150 MHz) par l'intermédiaire d'une parabole et d'un convertisseur à faible bruit situé au foyer de la parabole.

Ce signal est ensuite envoyé à l'entrée du synthonisateur du récepteur. Le synthonisateur a pour but de sélectionner le canal désiré et de sortir un signal en bande de base sur la voie en phase (voie I) et sur la voie en quadrature (voie Q). Ce signal est ensuite converti en un signal numérique et démodulé. Les traitements de décodage de canal comportent ensuite également un bloc qui distingue, typiquement au moyen d'une logique majoritaire les "0" des "1", puis effectue l'ensemble de la correction d'erreur, c'est-à-dire typiquement un décodage de Viterbi, le désentrelacement, un décodage de Reed-Solomon, et le débrassage. Le dispositif de décodage de canal fournit en sortie des paquets qui sont décodés de façon classique dans un dispositif de décodage de source conforme aux normes MPEG, de façon à redélivrer en sortie les signaux audio et vidéo initiaux transmis via le satellite.

Le synthonisateur est associé à un oscillateur local qui génère les signaux radiofréquence en quadrature. Il est indispensable de contrôler cette quadrature le mieux possible, car toute erreur de quadrature entre les signaux issus de l'oscillateur et délivrés aux mélangeurs du synthonisateur conduit à une imprécision sur le décodage de l'information numérique reçue. Et, ce contrôle de la quadrature doit s'effectuer sur toute la plage de fréquence des signaux reçus. A titre indicatif, les spécifications de développement imposent par exemple une erreur de déphasage qui devra rester inférieure à quelques degrés, par exemple 3°.

Dans le domaine des téléphones portables, la transmission des données entre les téléphones portables et la base n'est pas continue mais sous forme de paquets. Et, entre la transmission de ces paquets, il est possible aux téléphones portables de recalibrer la quadrature de l'oscillateur local en injectant par exemple un signal de test.

Or, une telle calibration n'est pas possible en télévision numérique. En effet, l'information est transmise en continu et il n'y a pas de temps disponible pour effectuer une quelconque calibration de l'oscillateur local.

Une solution consiste alors à agir directement sur l'oscillateur local pour en améliorer la qualité. Cependant, ceci pose des problèmes technologiques importants, ce qui a une incidence directe sur le coût de fabrication.

On connaît par ailleurs par la thèse de doctorat présentée par Patricia COGET (12 juillet 1989, Université de Limoges) intitulée "Conception d'un déphaseur 0-90° monolithique large bande microonde pour faisceaux hertziens", un déphaseur 0-90° monolithique large bande, intégré sur substrat ASGA, pour récepteur de faisceaux hertziens. Afin de faire fonctionner ce circuit sur une large bande de fréquences, on utilise un système asservi constitué d'un déphaseur commandable, d'un comparateur de phase, d'un amplificateur et d'un filtre de boucle.

Cependant, un tel circuit présente de nombreux inconvénients.

L'un de ces inconvénients réside dans la structure du déphaseur qui est formée de cellules résistives capacitives, ce qui nécessite un appariement (matching en langue anglaise) très précis des composants lors de la réalisation du déphaseur. Par ailleurs, l'oscillateur local décrit dans ce document de l'art antérieur délivre deux signaux en opposition de phase à partir desquels sont formés quatre signaux mutuellement en quadrature. Or, si une erreur de déphasage existe entre les deux signaux délivrés par l'oscillateur local, cette erreur de déphasage subsiste également entre les deux signaux en opposition de phase délivrés par le déphaseur, ainsi qu'entre les deux autres signaux en opposition de phase également délivrés par le déphaseur.

En outre, l'asservissement selon cet art antérieur comporte une commande unique du déphaseur, ce qui est très pénalisant vis-à-vis d'une élimination d'un éventuel bruit. Enfin, un tel circuit n'est pas totalement intégré et, de toutes façons, ne se prêterait pas à une intégration complète sur un substrat de silicium en raison de la propention d'un tel substrat à propager du bruit.

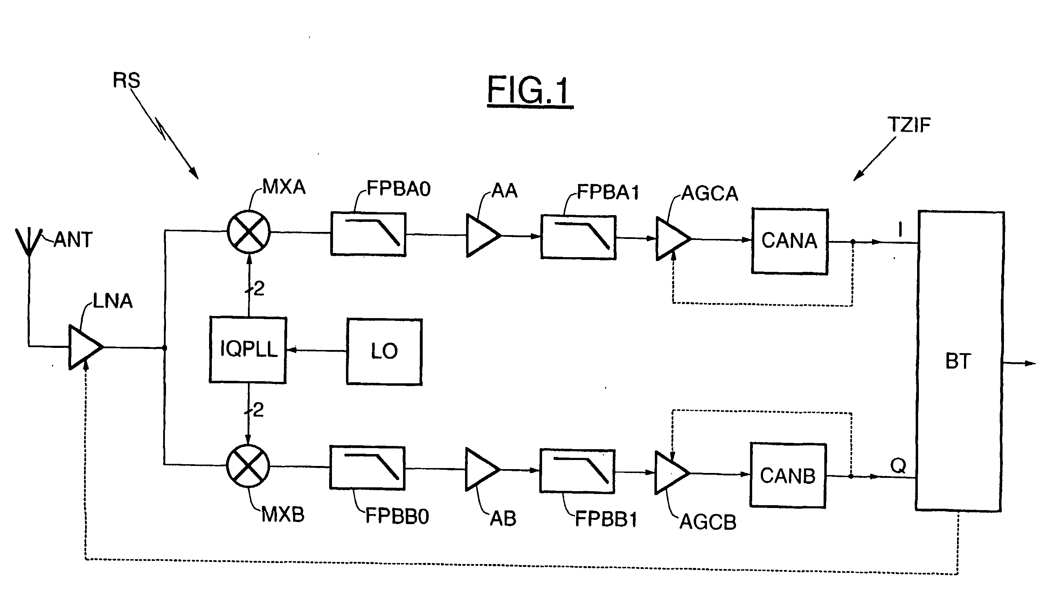

Le document FR-A-2670975 divulgue un appareil et un procédé de production de signaux en quadrature de phase avec un retard contrôlé au moyen d'un unique signal (voir la figure 1 dudit document).

L'invention vise à apporter une solution à ces problèmes.

Un but de l'invention est de proposer un contrôle du déphasage entre quatre signaux mutuellement en quadrature de phase, qui soit quasi insensible au bruit, simple à réaliser et totalement intégrable sur substrat-silicium.

Pour atteindre ces objectifs, l'invention propose notamment de contrôler le déphasage au moyen d'une boucle à verrouillage de phase entièrement différentielle. L'utilisation d'une structure différentielle rend le dispositif selon l'invention particulièrement insensible au bruit.

L'invention propose donc un procédé de contrôle du déphasage entre quatre signaux mutuellement en quadrature de phase, dans lequel on élabore à partir d'au moins un premier signal de base (par exemple un signal considéré comme signal de référence et ayant par conséquent une phase considérée comme nulle) et d'un deuxième signal de base (par exemple un signal ayant une phase de 90°) en quadrature par rapport au premier signal de base et susceptible de présenter une erreur de quadrature par rapport à ce premier signal de base, une première paire de signaux retardés par un premier retard ajustable. Cette première paire de signaux retardés comporte un premier signal retardé par rapport au premier signal de base et un deuxième signal retardé en opposition de phase par rapport au premier signal retardé.

On élabore également une deuxième paire de signaux retardés par un deuxième retard ajustable, cette deuxième paire comportant un troisième signal retardé par rapport au deuxième signal de base et un quatrième signal retardé en opposition de phase par rapport au troisième signal retardé.

On ajuste alors continuellement la valeur de chacun des retards à partir de deux signaux différentiels issus de mélanges croisés directs ou indirects des deux paires de signaux retardés, de façon à augmenter la valeur de l'un des deux retards et à diminuer la valeur de l'autre retard jusqu'à obtenir les quatre signaux retardés quasiment en quadrature, indépendamment de ladite erreur de quadrature.

Il convient de noter ici qu'au sens de la présente invention, un mélange direct signifie que l'on utilise directement les signaux retardés, tandis qu'un mélange indirect signifie que l'on utilise des signaux issus de ces signaux retardés, par exemple des signaux mis en forme.

Selon un mode de mise en oeuvre de l'invention, on mélange directement ou indirectement la première paire de signaux retardés avec la deuxième paire de signaux retardés, cette deuxième paire agissant en tant que commande du mélange, et on mélange directement ou indirectement la deuxième paire de signaux retardés avec la première paire de signaux retardés, cette première paire de signaux retardés agissant en tant que commande du mélange.

On obtient alors à l'issue de ces mélanges, une première paire de signaux différentiels et une deuxième paire de signaux différentiels, ces deux paires étant toutes deux représentatives de l'erreur de quadrature entre le premier signal retardé et le troisième signal retardé.

On filtre par un filtrage passe-bas et on somme les deux paires de signaux différentiels, de façon à obtenir une paire de signaux différentiels sommés.

On ajuste continuellement la valeur du premier retard à partir de l'un des deux signaux différentiels filtrés sommés, tandis qu'on ajuste continuellement la valeur du deuxième retard à partir de l'autre signal différentiel filtré sommé, de façon à augmenter la valeur de l'un des deux retards et à diminuer la valeur de l'autre retard jusqu'à obtenir les quatre signaux retardés quasiment en quadrature indépendamment de ladite erreur de quadrature.

Afin d'obtenir une meilleure efficacité lors du mélange, on met avantageusement en forme les signaux retardés avant mélange, de façon à les transformer par exemple en signaux carrés.

Afin d'obtenir une meilleure précision pour l'ajustement de la valeur des retards, on effectue avantageusement une intégration des deux signaux différentiels filtrés sommés, puis on effectue l'ajustement de la valeur des retards à partir de ces signaux différentiels intégrés.

Selon un mode de mise en oeuvre, on isole le filtre intégrateur du bruit généré lors de la phase de retardement des signaux de base.

Par ailleurs, alors qu'il serait possible théoriquement d'élaborer les paires de signaux retardés à partir uniquement du premier signal de base et du deuxième signal de base (en utilisant par exemple en outre les valeurs moyennes de ces signaux comme signaux supplémentaires), on élabore, selon un mode de mise en oeuvre de l'invention, ces paires de signaux retardés à partir non seulement de ces deux signaux de base, mais également à partir d'un troisième signal de base sensiblement en opposition de phase par rapport au premier signal de base et d'un quatrième signal de base sensiblement en opposition de phase par rapport au deuxième signal de base.

L'invention propose également un dispositif de contrôle du déphasage entre quatre signaux mutuellement en quadrature de phase, comprenant :
- un générateur possédant une première sortie pour générer au moins un premier signal de base et une deuxième sortie pour générer au moins un deuxième signal de base en quadrature par rapport au premier signal de base et susceptible de présenter une erreur de quadrature par rapport au premier signal de base, et
- une boucle différentielle à verrouillage de phase comportant :

- une première cellule de retard connectée à la première sortie du générateur et possédant une entrée de commande de retard, cette première cellule de retard étant apte à délivrer une première paire de signaux retardés par un premier retard ajustable, cette première paire de signaux retardés comportant un premier signal retardé par rapport au premier signal de base et un deuxième signal retardé en opposition de phase par rapport au premier signal retardé,
- une deuxième cellule de retard, connectée à la deuxième sortie du générateur et possédant une entrée de commande de retard, cette deuxième cellule de retard étant apte à délivrer une deuxième paire de signaux retardés par un deuxième retard ajustable, cette deuxième paire de signaux retardés comportant un troisième signal retardé par rapport au deuxième signal de base et un quatrième signal retardé en opposition de phase par rapport au troisième signal retardé,
- et des moyens d'ajustement différentiels, connectés entre les sorties des cellules de retards et leurs entrées de commande, et aptes à ajuster continuellement la valeur de chacun des retards à partir de deux signaux différentiels issus de mélanges croisés directs ou indirects des deux paires de signaux retardés, de façon à augmenter la valeur de l'un des deux retards et à diminuer la valeur de l'autre retard jusqu'à obtenir les quatre signaux retardés quasiment en quadrature, indépendamment de ladite erreur de quadrature.

Selon un mode de réalisation, les moyens d'ajustement différentiels comportent :
- un premier mélangeur connecté aux sorties de la première et de la deuxième cellules de retard, apte à mélanger directement ou indirectement la première paire de signaux retardés avec la deuxième paire de signaux retardés agissant en tant que commande du mélange, et à délivrer une première paire de signaux différentiels représentative de l'erreur de quadrature entre le premier signal retardé et le troisième signal retardé,
- un deuxième mélangeur connecté aux sorties de la première et de la deuxième cellules de retard, apte à mélanger directement ou indirectement la deuxième paire de signaux retardés avec la première paire de signaux retardés agissant en tant que commande du mélange, et à déliver une deuxième paire de signaux différentiels représentative de l'erreur de quadrature entre le premier signal retardé et le troisième signal retardé,
- un premier filtre passe-bas connecté aux deux sorties du premier mélangeur, un deuxième filtre passe-bas connecté aux deux sorties du deuxième mélangeur et des moyens de sommation connectés aux sorties des deux filtres passe-bas.

Par ailleurs, l'une des sorties des moyens de sommation est reliée à l'entrée de commande de retard de l'une des cellules de retard, tandis que l'autre sortie des moyens de sommation est reliée à l'entrée de commande de retard de l'autre cellule de retard, de façon à ajuster continuellement la valeur du premier retard et du deuxième retard en augmentant la valeur de l'un des deux retards et en diminuant la valeur de l'autre retard jusqu'à obtenir les quatre signaux retardés quasiment en quadrature, indépendamment de ladite erreur de quadrature.

Selon un mode de réalisation de l'invention, le dispositif comprend également des moyens de mise en forme de signaux connectés entre les entrées des mélangeurs et les sorties des cellules de retard.

Chaque cellule de retard comporte avantageusement un comparateur différentiel à charge variable.

Selon un mode de réalisation de l'invention, chaque mélangeur est un mélangeur passif en anneau formé de quatre transistors montés en anneau.

Le dispositif comprend par ailleurs avantageusement un filtre intégrateur différentiel actif avec contrôle de mode commun, connecté entre les deux sorties du sommateur et les deux entrées de commande de retard des deux cellules de retard.

Le dispositif comprend par ailleurs de préférence des moyens d'isolation connectés entre les sorties du filtre intégrateur et les deux entrées de commande de retard des deux cellules de retard, ces moyens d'isolation étant aptes à isoler le filtre intégrateur du bruit généré par les cellules de retard.

Le dispositif selon l'invention est avantageusement intégré sur silicium.

L'invention propose également un récepteur de signaux de télévision numérique par satellite, comprenant un dispositif de synthonisation incorporant un dispositif de contrôle de déphasage tel que défini ci-avant.

D'autres avantages et caractéristiques de l'invention apparaîtront à l'examen de la description détaillée de modes de mise en oeuvre et de réalisation, nullement limitatifs, et des dessins annexés, sur lesquels :
- la figure 1 illustre schématiquement un dispositif de synthonisation incorporé dans un récepteur satellite et contenant un dispositif de contrôle de déphasage selon l'invention;
- la figure 2 illustre plus en détail mais toujours schématiquement, la structure interne d'un mode de réalisation d'un dispositif de contrôle de déphasage selon l'invention; et
- les figures 3 à 7 illustrent plus en détail mais toujours schématiquement, certains éléments du dispositif de la figure 2.

Sur la figure 1, la référence RS désigne un récepteur/décodeur satellite ("set-top box" en langue anglaise) connecté à une antenne parabolique ANT captant des signaux de télévision numérique, et destiné à recevoir et à décoder ces signaux.

Ce récepteur RS comporte en tête un dispositif de synthonisation, ou tuner, TZIF, destiné à sélectionner le canal désiré parmi l'ensemble des canaux présents dans le signal reçu à l'entrée de signal de ce tuner.

Ce tuner TZIF, avantageusement entièrement réalisé de façon intégrée en technologie CMOS sur substrat de silicium, est du type à fréquence intermédiaire nulle, c'est-à-dire qu'il n'effectue pas de transposition de fréquence à une fréquence intermédiaire mais ne comporte qu'un seul étage de transposition de fréquence, comportant ici les mélangeurs MXA et MXB, et transposant directement le signal au voisinage de la bande de base d'un canal.

Le tuner TZIF comporte en tête, un amplificateur faible bruit à gain variable LNA connecté entre l'antenne et les mélangeurs MXA et MXB.

Un oscillateur LO délivre des signaux de base, en théorie au moins deux signaux de base en quadrature de phase (présentant par exemple respectivement une phase nulle et une phase de 90°), et en pratique quatre signaux mutuellement en quadrature de phase. Ces signaux de base sont délivrés à un dispositif de contrôle du déphasage IQPLL qui se compose d'une boucle à verrouillage de phase à structure différentielle. Cette boucle à verrouillage de phase délivre, comme on le verra plus en détail ci-après, au mélangeur MXA deux signaux différentiels en opposition de phase (présentant respectivement une phase nulle et une phase de 180°), et délivre au mélangeur MXB deux autres signaux en opposition de phase, mais en quadrature de phase par rapport aux deux signaux délivrés au mélangeur MXA.

La voie de traitement comportant le mélangeur MXA est donc ici la voie de référence (voie I), tandis que la voie de traitement contenant le mélangeur MXB est la voie en quadrature (voie Q).

En d'autres termes, la voie I représente le signal en phase, tandis que la voie Q représente le signal en quadrature.

Les mélangeurs MXA et MXB sont équipés en sortie de filtres passe-bas dont la fréquence de coupure est par exemple une bande passante de l'ordre de 150 à 250 MHz. Le signal de sortie des deux mélangeurs MXA et MXB est donc un signal centré autour de la fréquence 0 MHz, s'étendant sur une bande de fréquence de 150 à 250 MHz et comportant le canal sélectionné ainsi que les canaux immédiatement adjacents. La largeur d'un canal étant de l'ordre de 40 MHz pour des signaux de télévision numérique haute définition, les deux filtres en bande de base FPBA0 et FPBB0, qui suivent les deux mélangeurs MXA et MXB, ont une bande passante de l'ordre de 40 MHz. En conséquence, on retrouve en sortie de ces deux filtres à bande de base un signal filtré comportant uniquement le canal sélectionné.

Ces deux filtres en bande de base sont suivis des amplificateurs à gain fixe AA et AB, respectivement connectés aux entrées de convertisseurs analogiques numériques CANA et CANB par l'intermédiaire de deux autres filtres FPBA1 et FPBB 1 qui sont en fait des filtres d'anti-repliement, et de deux amplificateurs à gain commandé AGCA et AGCB.

Ces deux convertisseurs analogique-numérique CANA et CANB marquent la frontière entre le bloc analogique du tuner et le bloc numérique de ce tuner.

Les deux signaux numériques en quadrature I et Q délivrés par les convertisseurs analogique-numérique sont traités dans un bloc de calculs BT capable d'effectuer les traitements classiques ultérieurs de démodulation et de décodage de canal tels qu'un décodage de Viterbi, un désentrelacement, un décodage de Reed-Solomon, un débrassage, de façon à délivrer un flux de paquets qui seront décodés dans un bloc de décodage de source conforme à la norme MPEG, par exemple.

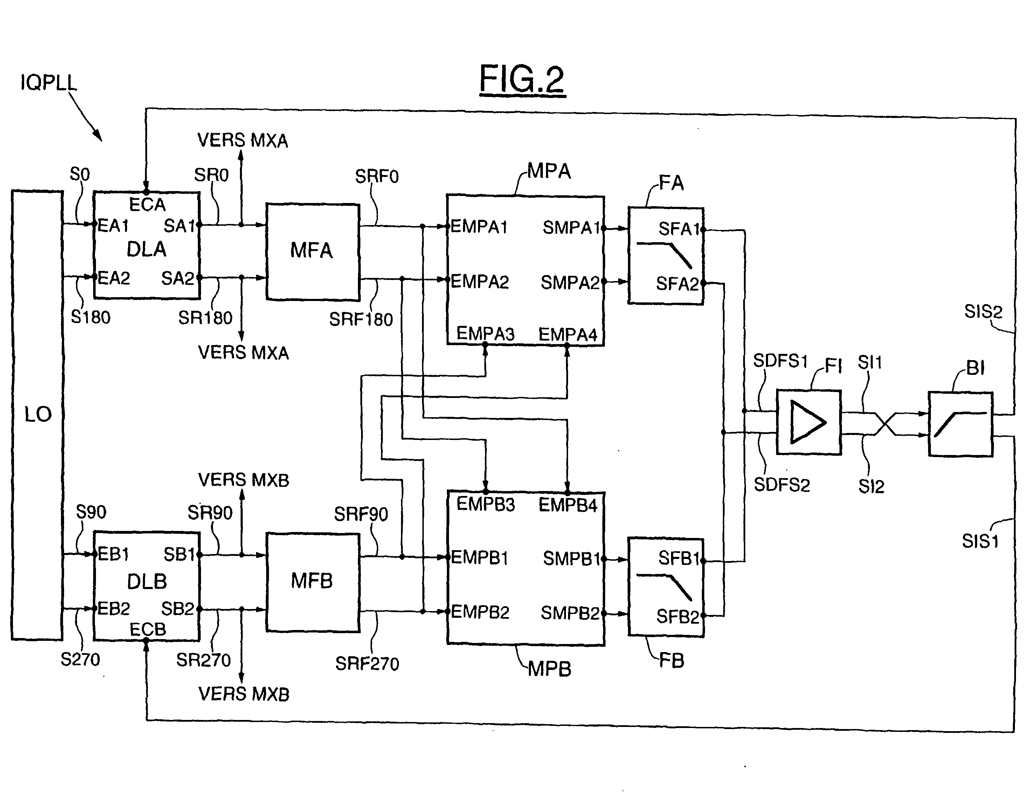

On fait référence maintenant plus particulièrement à la figure 2 pour décrire plus en détail le dispositif de contrôle de déphasage IQPLL.

Ce dispositif IQPLL, qui est en fait une boucle à verrouillage de phase à structure entièrement différentielle, reçoit de la part d'un oscillateur local de structure classique et connue en soi, quatre signaux de base mutuellement en quadrature de phase. Plus précisément, le premier signal de base est le signal S0, qui est le signal de référence en phase (phase nulle). Le deuxième signal de base est le signal S90, qui est un signal en quadrature de phase (90°) par rapport au premier signal de base S0. Ce deuxième signal de base S90 est susceptible de présenter une erreur de quadrature par rapport au premier signal de base, compte tenu des caractéristiques technologiques de l'oscillateur local.

Le troisième signal de base est ici le signal S180, sensiblement en opposition de phase (phase égale à 180°) par rapport au premier signal de base S0.

Le quatrième signal de base est ici le signal S270, sensiblement en opposition de phase par rapport au deuxième signal de base S90.

Les deux signaux de base S0 et S 180 (voie I ou signal I) sont délivrés aux deux entrées EA1 et EA2 d'une première cellule de retard DLA, sur la structure de laquelle on reviendra plus en détail ci-après. Cette première cellule de retard possède une entrée de commande de retard ECA.

Cette première cellule de retard est apte à délivrer sur ses deux sorties SA1 et SA2, une première paire de signaux retardés SR0 et SR180, ces signaux SR0 et SR180 étant retardés par un premier retard ajustable. Le premier signal retardé SR0 de la première paire de signaux retardés est retardé par rapport au premier signal de base S0 et le deuxième signal retardé SR180 est en opposition de phase par rapport au premier signal retardé SR0. L'ajustement du retard se fait par la commande arrivant sur l'entrée de commande ECA.

D'une façon analogue, la boucle IQPLL comporte également une deuxième cellule de retard DLB, de structure analogue à celle de la première cellule de retard DLA. Cette deuxième cellule de retard reçoit sur ses deux entrées EB 1 et EB2 les deux signaux de base S90 et S270 (voie Q ou signal Q) et délivre sur ses deux sorties SB1 et SB2 une deuxième paire de signaux retardés SR90 et SR270, ces deux signaux SR90 et SR270 sont retardés par un deuxième retard ajustable. L'ajustement de ce deuxième retard s'effectue par la commande reçue sur l'entrée de commande ECB de la cellule DLB.

Le troisième signal retardé SR90, faisant partie de la deuxième paire de signaux retardés, est retardé par rapport au deuxième signal de base S90, tandis que le quatrième signal retardé SR270 est en opposition de phase par rapport au troisième signal retardé SR90.

Ce sont ces quatre signaux retardés SR0, SR180, SR90 et SR270 qui sont délivrés aux deux mélangeurs MXA et MXB du tuner.

Comme on le verra plus en détail ci-après, la valeur du premier retard de la première cellule de retard DLA et la valeur du deuxième retard de la deuxième cellule de retard DLB sont continuellement ajustées jusqu'à obtenir les quatre signaux retardés quasiment en quadrature, indépendamment de l'erreur de quadrature possible entre les signaux de base.

Les deux signaux retardés SR0 et SR180, qui sont par exemple des signaux sinusoïdaux, sont ensuite mis en forme dans un circuit classique de mise en forme MFA de façon à être transformés en des signaux carrés (0-1,8 volts par exemple) SRF0 et SRF180.

De même, les deux signaux retardés SR90 et SR270 sont transformés en des signaux carrés SRF90 et SRF270 par un circuit de mise en forme MFB.

La boucle IQPLL comporte également un premier mélangeur MPA, par exemple comme on le verra plus en détail ci-après un mélangeur passif en anneau, recevant sur deux de ses entrées EMPA1 et EMPA2 les deux signaux mis en forme SRF0 et SRF180, et recevant sur deux autres entrées EMPA3 et EMPA4 les deux signaux mis en forme SRF90 et SRF270. En d'autres termes, le premier mélangeur MPA mélange ici directement les deux signaux SRF0 et SRF180 avec les deux signaux SRF90 et SRF270 (indirectement la première paire de signaux retardés SR0 et SR180 avec la deuxième paire de signaux retardés SR90 et SR270) qui agissent en tant que commande du mélange. Le mélangeur MPA délivre alors sur ses deux sorties SMPA 1 et SMPA2 une première paire de signaux différentiels qui est représentative de l'erreur de quadrature entre le premier signal retardé SR0 et le troisième signal retardé SR90.

De même, la boucle IQPLL comporte un deuxième mélangeur MPB, par exemple de structure analogue à celle du premier mélangeur MPA, qui est connecté aux sorties de la première et de la deuxième cellules de retard. Plus précisément, ce deuxième mélangeur reçoit sur deux de ses entrées EMPB 1 et EMPB2 les signaux mis en forme SRF90 et SRF270. Il reçoit par ailleurs sur ses deux autres entrées EMPB3 et EMPB4 les signaux mis en forme SRF0 et SRF180.

Ce deuxième mélangeur mélange donc indirectement la deuxième paire de signaux retardés SR90 et SR270 avec la première paire de signaux retardés SR0 et SR180, qui agit cette fois-ci en tant que commande du mélange. Le mélangeur MPB délivre alors sur ses deux sorties SMPB1 et SMPB2 une deuxième paire de signaux différentiels également représentatifs de l'erreur de quadrature entre le premier signal retardé et le troisième signal retardé.

En d'autres termes, on mélange la voie I par la voie Q et la voie Q par la voie I, ce qui permet d'obtenir des harmoniques des signaux I et des harmoniques des signaux Q, ainsi que deux paires de signaux différentiels. La différence des deux signaux différentiels continus de chaque paire est alors proportionnelle au déphasage entre la voie I et la voie Q.

On filtre ensuite chacun des signaux différentiels délivrés sur les sorties SMPA1 et SMPA2 dans un filtre passe-bas, par exemple un filtre passe-bas classique RC, de façon à obtenir en sortie SFA 1 et SFA2 de ce filtre FA la valeur moyenne de chacun des deux signaux différentiels.

On effectue la même opération dans un deuxième filtre passe-bas FB connecté aux sorties SMPB1 et SMPB2 du deuxième mélangeur MPB.

On somme ensuite deux à deux les valeurs moyennes délivrées en sortie des deux filtres passe-bas. Les moyens de sommation sont ici réalisés en reliant simplement la sortie SFB2 du filtre FB avec la sortie SFA2 du filtre FA et en reliant la sortie SFB 1 du filtre FB avec la sortie homologue SFA 1 du filtre FA. A la sortie de ces moyens de sommation, on obtient une paire de signaux différentiels filtrés sommés SDFS1 et SDFS2.

Alors qu'il serait possible d'ajuster continuellement la valeur du premier retard de la première cellule de retard DLA à partir du signal SDFS2, et d'ajuster continuellement la valeur du retard de la deuxième cellule de retard DLB à partir du signal SDFS 1, il est préférable, pour des raisons de précision et d'isolement de bruit, d'interposer entre la sortie des moyens de sommation et les entrées de commande des cellules de retard, un filtre actif intégrateur FI suivi d'un bloc d'isolation BI.

La fonction du filtre intégrateur différentiel actif FI est d'intégrer sur une durée prédéterminée chacun des signaux différentiels SDFS1 et SDFS2, de façon à augmenter le niveau de ces signaux et d'ajuster avec plus de précision la valeur des retards à partir de ces signaux intégrés SI1 et SI2. Les deux signaux intégrés SI1 et SI2 sont ensuite délivrés à un bloc d'isolation dont la fonction est d'isoler le filtre intégrateur du bruit généré par les cellules de retard DLA et DLB. Et, c'est à partir des signaux SIS 1 et SIS2 délivrés par le bloc d'isolation BI que l'on va ajuster la valeur du retard de chacune des cellules de retard.

Cet ajustement va consister à augmenter la valeur de l'un des deux retards et à diminuer la valeur de l'autre retard jusqu'à obtenir les quatre signaux retardés SR0, SR180, SR90 et SR270 quasiment en quadrature indépendamment de ladite erreur de quadrature. A cet égard, c'est avec le signal SIS 1 issu de la première voie de traitement (voie I) que l'on commande le retard de la deuxième cellule de retard DLB, tandis que c'est avec le signal SIS2 issu de la deuxième voie de traitement (voie Q) que l'on commande le retard de la première cellule de retard DLA.

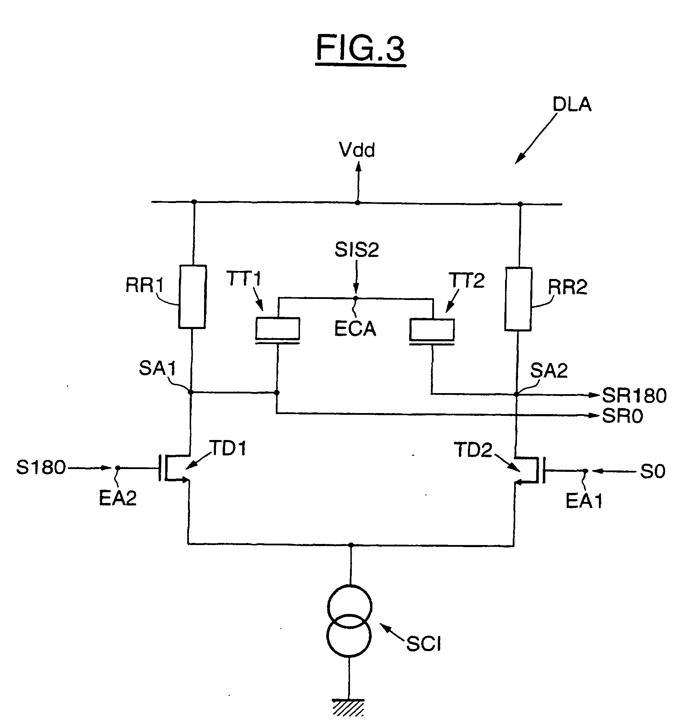

Alors que toute structure classique de cellule de retard pourrait convenir à la présente invention, la structure particulière illustrée sur la figure 3 présente un avantage important en ce sens qu'une telle structure permet de corriger automatiquement toute erreur de déphasage entre deux signaux de base en opposition de phase.

A des fins de simplification, la figure 3 illustre la structure interne de la cellule DLA, étant bien entendu que la cellule DLB présente une structure analogue. Avec une telle structure, même si les deux signaux de base S0 et S 180 présentent une erreur de déphasage, les deux signaux retardés SR0 et SR180 seront certes retardés par rapport aux signaux respectifs S 180 et S0, mais rigoureusement en opposition de phase.

Plus précisément, une telle cellule DLA comporte un comparateur différentiel à charge variable. Ce comparateur différentiel à charge variable comporte ici deux transistors NMOS TD 1 et TD2 dont les grilles respectives forment les deux entrées EA2 et EA1 de la cellule de retard. Les sources de ces deux transistors sont polarisées par une source de courant SCI. Les drains de ces deux transistors sont également polarisés par deux résistances de polarisation RR1 et RR2. Les drains de ces deux transistors forment respectivement les deux sorties SA1 et SA2 de la cellule de retard.

Aux deux sorties SA1 et SA2, sont respectivement connectées les grilles de deux transistors NMOS TT1 et TT2, dont les drains et sources sont reliées ensemble et forment l'entrée de commande ECA de la cellule de retard. Chaque transistor NMOS est polarisé en appauvrissement (depletion en langue anglaise) afin de présenter une capacité dépendante du niveau du signal SIS2 délivré sur l'entrée de commande ECA. Le niveau du signal SIS2 délivré sur l'entrée de commande ECA fait varier la charge (produit RC). Si la charge augmente, le gain augmente ainsi que le retard conféré par la première cellule de retard. Si, a contrario, la charge diminue, le gain diminue ainsi que la valeur du retard.

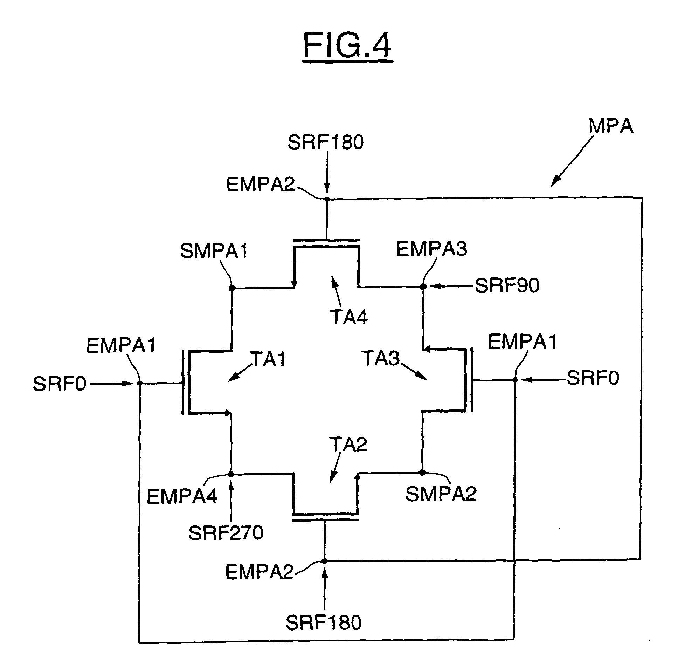

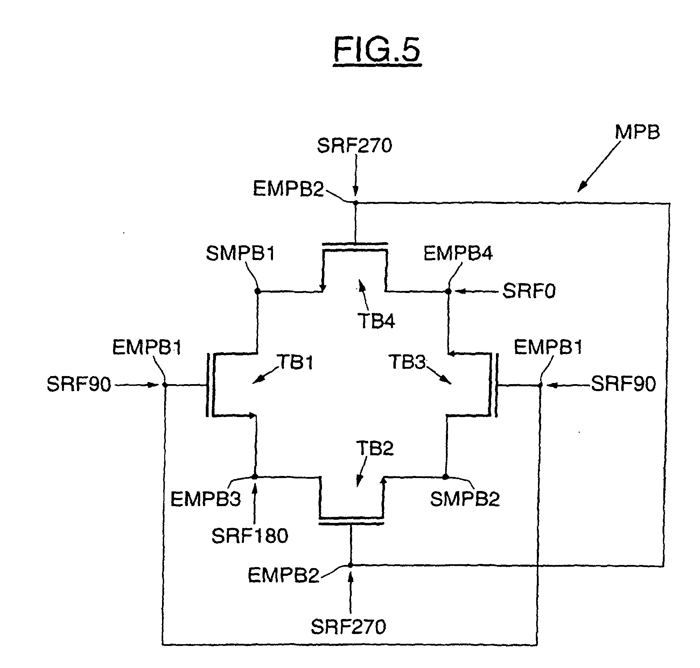

En d'autres termes, on contrôle le retard en faisant varier la charge, ce qui conduit à des signaux de sortie n'ayant pas les mêmes amplitudes. Aussi, est-il préférable de remettre en forme ces signaux avant d'attaquer les mélangeurs passifs MPA et MPB ayant une structure en anneau qui va maintenant être décrite en détail en se référant plus particulièrement aux figures 4 et 5.

La figure 4 illustre la structure du mélangeur MPA. Celui-ci est constitué de quatre transistors NMOS TA1-TA4. La grille du transistor TA1 est reliée à la grille du transistor TA3. Ces deux grilles forment ensemble l'entrée EMPA1 du mélangeur. De même, les grilles des transistors TA2 et TA4 sont reliées ensemble et forment l'entrée EMPA2 du mélangeur MPA.

La source du transistor TA1 est reliée au drain du transistor TA2 et forment ensemble l'entrée EMPA4. La source du transistor TA3 est reliée au drain du transistor TA4 et forment ensemble l'entrée EMPA3 du mélangeur.

La source du transistor TA4 est reliée au drain du transistor TA1 et forment ensemble la sortie SMPA1, tandis que la source du transistor TA2 est reliée au drain du transistor TA3 et forment ensemble la sortie SMPA2.

S'il existe une quadrature parfaite entre le signal SFR0 et SFR90, alors la valeur moyenne du signal impulsionnel délivré à la sortie SMPA1 est égale à la valeur moyenne du signal impulsionnel délivré à la sortie SMPA2. Par contre, s'il existe un déphasage entre les signaux SFR0 et SFR90, ces deux valeurs moyennes sont différentes.

La structure et le fonctionnement du mélangeur MPB, illustré sur la figure 5, est analogue à celle qui vient d'être décrite en référence à la figure 4.

L'utilisation de deux mélangeurs permet d'équilibrer les charges entre les quatre signaux retardés et mis en forme SRF0, SRF90, SRF180 et SRF270.

Par ailleurs, les transistors fonctionnant en mode bloqué-passant, il est particulièrement avantageux d'utiliser des signaux mis en forme carrés au lieu de signaux sinusoïdaux.

Enfin, l'utilisation de transistors NMOS permet d'avoir des signaux de sortie des mélangeurs ayant des niveaux inférieurs à Vdd-Vt (Vdd désignant la tension d'alimentation, tandis que Vt désigne la tension de seuil d'un transistor NMOS). Ainsi, le fonctionnement du filtre actif intégrateur peut s'effectuer aisément dans le domaine linéaire.

Après filtrage, le signal SDFS 1 et le signal SDFS2 sont chacun représentatifs de la différence entre les valeurs moyennes des deux sorties des deux mélangeurs.

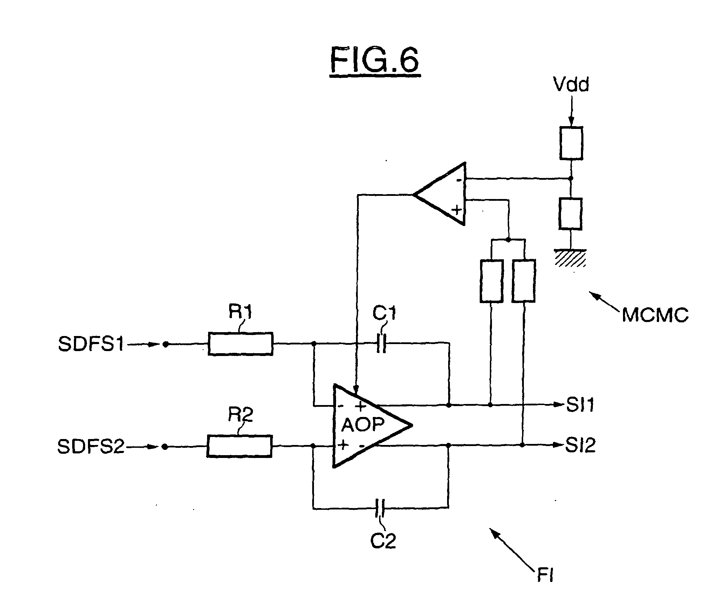

Chaque signal SDFS1 et SDFS2 est intégré dans le filtre intégrateur différentiel actif dont un exemple de structure est illustré sur la figure 6. Ce filtre FI est un filtre intégrateur résistif-capacitif ayant par exemple une fréquence de coupure de l'ordre de 300 KHz, dont la fonction est d'amplifier dans le temps chacun des signaux SDFS1 et SDFS2.

Ce filtre actif comporte ici un amplificateur différentiel opérationnel AOP, dont chaque sortie est reliée sur l'entrée opposée par l'intermédiaire d'un condensateur C1, C2. Par ailleurs, des résistances R1, R2 sont respectivement connectées entre les deux entrées du filtre FI et les deux entrées de l'amplificateur opérationnel AOP.

Le filtre actif FI comporte ici des moyens MCMC de contrôle de mode commun. Plus précisément, ces moyens MCMC comportent d'autres résistances connectées respectivement entre les deux sorties de l'amplificateur AOP et l'une des entrées (+) d'un comparateur. Ces deux résistances ont pour fonction d'effectuer la moyenne des deux sorties de l'amplificateur AOP.

L'autre entrée (entrée inverseuse) du comparateur est reliée à la tension Vdd/2 par l'intermédiaire d'un pont résistif connecté entre la tension Vdd et la masse. La sortie du comparateur contrôle la charge de l'amplificateur opérationnel différentiel AOP.

Les moyens MCMC ont donc pour fonction de fixer le mode commun de sortie à la tension Vdd/2, ce qui permet de centrer à Vdd/2 la valeur de commande des retards afin d'obtenir la plage maximale de commande des cellules de retard.

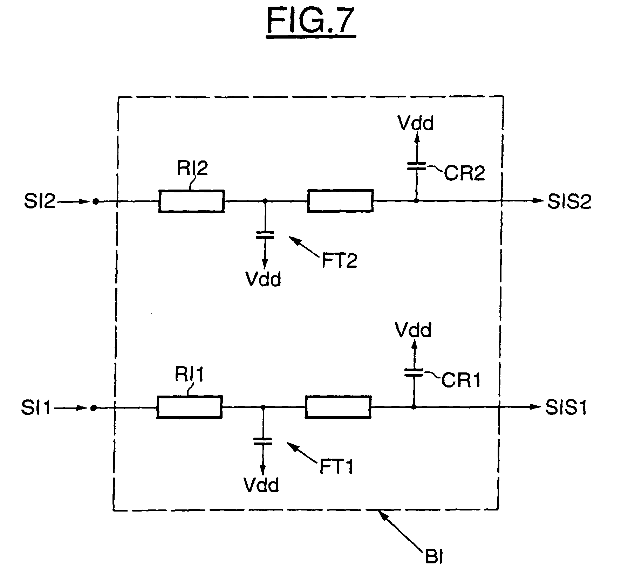

La structure du bloc d'isolation BI est illustrée sur la figure 7.

Ce bloc BI comporte en fait deux voies d'isolation présentant une structure analogue. Chaque voie comporte un filtre en T, FT1, FT2. Ce filtre en T est un filtre résistif-capacitif agissant en tant que filtre passe-bas vu depuis les cellules de retard.

Afin que la capacité du filtre en T ne soit pas directement connectée à la sortie correspondante de l'amplificateur opérationnel, il est prévu une résistance d'isolement RI1, RI2. Enfin, des capacités CR1, CR2 sont connectées entre la sortie de chaque filtre en T et la tension d'alimentation Vdd. Ces deux capacités forment des réservoirs d'énergie en cas de baisse d'alimentation et permettent ainsi de mieux maintenir le potentiel sur la cellule de retard correspondante.

Selon l'invention, il est possible de réaliser un dispositif de contrôle du déphasage IQPLL entre quatre signaux mutuellement en quadrature de phase, complètement intégré en technologie CMOS 0,18µm.

A titre indicatif le dispositif selon l'invention permet de corriger des erreurs de quadrature entre les signaux de base issus de l'oscillateur LO, dans une plage s'étendant entre 0,9 et 2,3 GHz avec une possibilité maximale de correction de phase de ± 0,8° / 100Mhz.

En outre le bruit de phase total en sortie du dispositif selon l'invention est réduit dans sa bande passante en boucle fermée, de 3 dB sur chaque signal de sortie et le bruit de phase différentiel est diminué de 20 dB / décade.

## Revendications

1. Procédé de contrôle du déphasage entre quatre signaux mutuellement en quadrature de phase, **caractérisé par le fait qu'**on élabore à partir d'au moins un premier signal de base (S0) et d'un deuxième signal de base (S90) en quadrature par rapport au premier signal de base et susceptible de présenter une erreur de quadrature par rapport au premier signal de base, une première paire de signaux retardés par un premier retard ajustable comportant un premier signal (SR0) retardé par rapport au premier signal de base (S0) et un deuxième signal retardé (SR180) en opposition de phase par rapport au premier signal retardé, et une deuxième paire de signaux retardés par un deuxième retard ajustable comportant un troisième signal (SR90) retardé par rapport au deuxième signal de base et un quatrième signal retardé (SR270) en opposition de phase par rapport au troisième signal retardé, et on ajuste continuellement la valeur de chacun des retards à partir de deux signaux différentiels (SIS2, SIS1) issus de mélanges croisés directs ou indirects des deux paires de signaux retardés de façon à augmenter la valeur de l'un des deux retards et à diminuer la valeur de l'autre retard jusqu'à obtenir les quatre signaux retardés quasiment en quadrature indépendamment de ladite erreur de quadrature.

2. Procédé selon la revendication 1, **caractérisé par le fait que** dans l'étape d'ajustement, on mélange directement ou indirectement la première paire de signaux retardés (SR0, SR180) avec la deuxième paire de signaux retardés (SR90, SR270) agissant en tant que commande du mélange et on mélange directement ou indirectement la deuxième paire de signaux retardés (SR90, SR270) avec la première paire de signaux retardés (SR0, SR180) agissant en tant que commande du mélange, de façon à obtenir une première paire de signaux différentiels et une deuxième paire de signaux différentiels toutes deux représentatives de l'erreur de quadrature entre le premier signal retardé (SR0) et le troisième signal retardé (SR90), on filtre par un filtrage passe-bas (FA, FB) et on somme les deux paires de signaux différentiels de façon à obtenir une paire de signaux différentiels filtrés sommés (SDFS1, SDFS2), et on ajuste continuellement la valeur du premier retard à partir de l'un des deux signaux différentiels filtrés sommés tandis qu'on ajuste continuellement la valeur du deuxième retard à partir de l'autre signal différentiel filtré sommé de façon à augmenter la valeur de l'un des deux retards et à diminuer la valeur de l'autre retard jusqu'à obtenir les quatre signaux retardés quasiment en quadrature indépendamment de ladite erreur de quadrature.

3. Procédé selon la revendication 1 ou 2, **caractérisé par le fait qu'**on met en forme (MFA, MFB) les signaux retardés avant mélange.

4. Procédé selon l'une des revendications précédentes, **caractérisé par le fait qu'**on effectue une intégration (FI) des deux signaux différentiels filtrés sommés, et on effectue l'ajustement de la valeur des retards à partir de ces signaux différentiels intégrés (SI1, SI2).

5. Procédé selon la revendication 4, **caractérisé par le fait qu'**on isole le filtre intégrateur (FI) du bruit généré lors de la phase de retardement des signaux de base.

6. Procédé selon l'une des revendications précédentes, **caractérisé par le fait qu'**on élabore les paires de signaux retardés à partir du premier signal de base (S0), du deuxième signal de base (S90), d'un troisième signal de base (S180) sensiblement en opposition de phase par rapport au premier signal de base et d'un quatrième signal de base (S270) sensiblement en opposition de phase par rapport au deuxième signal de base.

7. Dispositif de contrôle du déphasage entre quatre signaux mutuellement en quadrature de phase, **caractérisé par le fait qu'**il comprend un générateur (LO) possédant une première sortie pour générer au moins un premier signal de base (S0) et une deuxième sortie pour générer au moins un deuxième signal de base (S90) en quadrature par rapport au premier signal de base et susceptible de présenter une erreur de quadrature par rapport au premier signal de base, et une boucle différentielle à verrouillage de phase (IQPLL) comportant
une première cellule de retard (DLA) connectée à la première sortie du générateur et possédant une entrée de commande de retard, apte à délivrer une première paire de signaux retardés par un premier retard ajustable comportant un premier signal retardé par rapport au premier signal de base et un deuxième signal retardé en opposition de phase par rapport au premier signal retardé,
une deuxième cellule de retard (DLB) connectée à la deuxième sortie et possédant une entrée de commande de retard, apte à délivrer une deuxième paire de signaux retardés par un deuxième retard ajustable comportant un troisième signal retardé par rapport au deuxième signal de base et un quatrième signal retardé en opposition de phase par rapport au troisième signal retardé, et
des moyens d'ajustement différentiels, connectés entre les sorties des cellules de retard et leurs entrées de commande, et aptes à ajuster continuellement la valeur de chacun des retards à partir de deux signaux différentiels (SIS2, SIS1) issus de mélanges croisés directs ou indirects des deux paires de signaux retardés, de façon à augmenter la valeur de l'un des deux retards et à diminuer la valeur de l'autre retard jusqu'à obtenir les quatre signaux retardés quasiment en quadrature indépendamment de ladite erreur de quadrature.

8. Dispositif selon la revendication 7, **caractérisé par le fait que** les moyens d'ajustement comportent
un premier mélangeur (MPA), connecté aux sorties de la première et de la deuxième cellule de retard, apte à mélanger directement ou indirectement la première paire de signaux retardés avec la deuxième paire de signaux retardés agissant en tant que commande du mélange, et à délivrer une première paire de signaux différentiels représentative de l'erreur de quadrature entre le premier signal retardé et le troisième signal retardé,
un deuxième mélangeur (MPB), connecté aux sorties de la première et de la deuxième cellule de retard, apte à mélanger directement ou indirectement la deuxième paire de signaux retardés avec la première paire de signaux retardés agissant en tant que commande du mélange, et à délivrer une deuxième paire de signaux différentiels représentative de l'erreur de quadrature entre le premier signal retardé et le troisième signal retardé,
un premier filtre passe-bas (FA) connecté aux deux sorties du premier mélangeur, un deuxième filtre passe-bas (FB) connecté aux deux sorties du deuxième mélangeur, et des moyens de sommation connectés aux sorties des deux filtres passe-bas,
et **par le fait que** l'une des sorties des moyens de sommation est reliée à l'entrée de commande de retard de l'une des cellules de retard, tandis que l'autre sortie des moyens de sommation est reliée à l'entrée de commande de retard de l'autre cellule de retard, de façon à ajuster continuellement la valeur du premier retard et du deuxième retard en augmentant la valeur de l'un des deux retards et en diminuer la valeur de l'autre retard jusqu'à obtenir les quatre signaux retardés quasiment en quadrature indépendamment de ladite erreur de quadrature.

9. Dispositif selon la revendication 7 ou 8, **caractérisé par le fait qu'**il comprend des moyens de mise en forme de signaux (MFA, MFB) connectés entre les entrées des mélangeurs et les sorties des cellules de retard.

10. Dispositif selon l'une des revendications 7 à 9, **caractérisé par le fait que** chaque cellule de retard (DLA, DLB) comporte un comparateur différentiel à charge variable.

11. Dispositif selon l'une des revendications 7 à 10, **caractérisé par le fait que** chaque mélangeur (MPA, MPB) est un mélangeur passif en anneau formé de quatre transistors monté en anneau.

12. Dispositif selon l'une des revendications 7 à 11, **caractérisé par le fait qu'**il comprend un filtre intégrateur différentiel actif (FI) avec contrôle de mode commun (MCMC), connecté entre les deux sorties du sommateur et les deux entrées de commande de retard des deux cellules de retard.

13. Dispositif selon la revendication 12, **caractérisé par le fait qu'**il comprend des moyens d'isolation (BI) connectés entre les sorties du filtre intégrateur et les deux entrées de commande de retard des deux cellules de retard, et aptes à isoler le filtre intégrateur du bruit généré par les cellules de retard.

14. Dispositif selon l'une des revendications 7 à 13, **caractérisé par le fait que** le générateur (LO) est apte à générer sur sa première sortie le premier signal de base et un troisième signal de base sensiblement en opposition de phase par rapport au premier signal de base et à générer sur sa deuxième sortie le deuxième signal de base et un quatrième signal de base sensiblement en opposition de phase par rapport au deuxième signal de base.

15. Dispositif selon l'une des revendications 7 à 14, **caractérisé par le fait qu'**il est intégré sur silicium.

16. Récepteur de signaux de télévision numériques par satellite, **caractérisé par le fait qu'**il comprend un dispositif de synthonisation (TZIF) incorporant un dispositif selon l'une des revendications 7 à 15.

## Patentansprüche

1. Verfahren zur Steuerung der Phasenverschiebung zwischen vier Signalen, die zueinander in Phasenquadratur sind, **dadurch gekennzeichnet, daß**
ausgehend von mindestens einem ersten Basissignal (S0) und mindestens einem zweiten Basissignal (S90), das bezüglich des ersten Basissignals in Quadratur ist und möglicherweise einen Quadraturfehler in bezug auf das erste Basissignal aufweisen könnte,
ein erstes Paar von Signalen, die um eine erste anpaßbare Verzögerung verzögert sind, wobei das Paar ein bezüglich des ersten Basissignals (S0) verzögertes erstes Signal (SR0) und ein verzögertes zweites Signal (SR180) aufweist, das eine bezüglich des ersten verzögerten Signals entgegengesetzte Phase hat, und
ein zweites Paar von Signalen, die durch eine zweite anpaßbare Verzögerung verzögert sind, wobei das Paar ein bezüglich des zweiten Basissignals verzögertes drittes Signal (SR90) und ein viertes verzögertes Signal (SR270) aufweist, das eine bezüglich des dritten verzögerten Signals entgegengesetzte Phase hat,
ausgearbeitet wird, und
ausgehend von zwei Differenzsignalen (SIS2, SIS1), die aus direkten oder indirekten gekreuzten Mischungen der zwei Paare von verzögerten Signalen hervorgehen, kontinuierlich der Wert jeder der Verzögerungen angepaßt wird, um den Wert der einen der zwei Verzögerungen zu erhöhen und den Wert der anderen Verzögerung zu verringern, bis unabhängig von dem Quadraturfehler die vier verzögerten Quasiquadratursignale erzielt sind.

2. Verfahren nach Anspruch 1, **dadurch gekennzeichnet, daß** im Anpassungsschritt das erste Paar von verzögerten Signalen (SR0,SR180) mit dem zweiten Paar von verzögerten Signalen (SR90,SR270), das als Mischbefehl wirkt, direkt oder indirekt gemischt wird, und das zweite Paar von verzögerten Signalen (SR90,SR270) mit dem ersten Paar von verzögerten Signalen (SR0,SR180), das als Mischbefehl wirkt, direkt oder indirekt gemischt wird, um ein erstes Paar von Differenzsignalen und ein zweites Paar von Differenzsignalen zu erzielen, wobei diese beiden Paare Quadraturfehler zwischen dem ersten verzögerten Signal (SR0) und dem dritten verzögerten Signal (SR90) repräsentieren,
die beiden Paare von Differenzsignalen mittels eines Tiefpaßfilters (FA,FB) gefiltert und addiert werden, um ein Paar von gefilterten addierten Differenzsignalen (SDFS1,SDFS2) zu erzielen, und
ausgehend von einem der zwei gefilterten addierten Differenzsignale der Wert der ersten Verzögerung kontinuierlich angepaßt wird, während ausgehend von dem anderen gefilterten addierten Differenzsignal der Wert der zweiten Verzögerung kontinuierlich angepaßt wird, um den Wert der einen der zwei Verzögerungen zu erhöhen und den Wert der anderen Verzögerung zu verringern, bis unabhängig von dem Quadraturfehler die vier verzögerten Quasiquadratursignale erzielt sind.

3. Verfahren nach Anspruch 1 oder 2, **dadurch gekennzeichnet, daß** vor dem Mischen die verzögerten Signale in Form (MFA,MFB) gebracht werden.

4. Verfahren nach einem der vorstehenden Ansprüche, **dadurch gekennzeichnet, daß** eine Integration (FI) der zwei gefilterten addierten Differenzsignale ausgeführt wird und die Anpassung des Werts der Verzögerungen ausgehend von diesen integrierten Differenzsignalen (SI1,SI2) ausgeführt wird.

5. Verfahren nach Anspruch 4, **dadurch gekennzeichnet, daß** das Integrationsfilter (FI) von dem Rauschen, das während der Verzögerungsphase der Basissignale erzeugt wird, isoliert wird.

6. Verfahren nach einem der vorstehenden Ansprüche, **dadurch gekennzeichnet, daß** ausgehend von dem ersten Basissignal (S0), dem zweiten Basissignal (S90), einem dritten Basissignal (S180), das bezüglich des ersten Basissignals eine im wesentlichen entgegengesetzte Phase hat, und einem vierten Basissignal (S270), das bezüglich des zweiten Basissignals eine im wesentlichen entgegengesetzte Phase hat, die Paare von verzögerten Signalen ausgearbeitet werden.

7. Vorrichtung zur Steuerung der Phasenverschiebung zwischen vier Signalen, die zueinander in Phasenquadratur sind, **dadurch gekennzeichnet, daß** die Vorrichtung aufweist:
einen Generator (LO), der einen ersten Ausgang zur Erzeugung mindestens eines ersten Basissignals (SO) und einen zweiten Ausgang zur Erzeugung mindestens eines zweiten Basissignals (S90) aufweist, das bezüglich des ersten Basissignals in Quadratur ist und möglicherweise einen Quadraturfehler bezüglich des ersten Basissignals aufweisen könnte, und
eine differentielle Phasenverriegelungsschleife (IQPLL), die aufweist:
eine erste Verzögerungszelle (DLA), die mit dem ersten Ausgang des Generators verbunden ist und einen Verzögerungssteuereingang aufweist, wobei die Zelle in der Lage ist, ein erstes Paar von Signalen auszugeben, die um eine erste anpaßbare Verzögerung verzögert sind, und wobei das Paar ein erstes verzögertes Signal, das bezüglich des ersten Basissignals verzögert ist, und ein zweites verzögertes Signal aufweist, das eine bezüglich des ersten verzögerten Signals entgegengesetzte Phase hat,
eine zweite Verzögerungszelle (DLB), die mit dem zweiten Ausgang des Generators verbunden ist und einen Verzögerungssteuereingang aufweist, wobei die Zelle in der Lage ist, ein zweites Paar von Signalen auszugeben, die um eine zweite anpaßbare Verzögerung verzögert sind, und wobei das Paar ein drittes verzögertes Signal, das bezüglich des zweiten Basissignals verzögert ist, und ein viertes verzögertes Signal aufweist, das bezüglich des dritten verzögerten Signals entgegengesetzte Phase hat, und
differentielle Anpassungseinrichtungen, die zwischen den Ausgängen der Verzögerungszellen und ihren Steuereingängen angeordnet sind und in der Lage sind, ausgehend von zwei Differenzsignalen (SIS2,SIS1), die aus direkten oder indirekten gekreuzten Mischungen der zwei Paare von verzögerten Signalen hervorgehen, den Wert jeder der Verzögerungen kontinuierlich anzupassen, um den Wert einer der Verzögerungen zu erhöhen und den Wert der anderen Verzögerung zu verringern, bis unabhängig von dem Quadraturfehler die vier verzögerten Quasiquadratursignale erzielt sind.

8. Vorrichtung nach Anspruch 7, **dadurch gekennzeichnet, daß** die Anpassungseinrichtungen aufweisen:
einen mit den Ausgängen der ersten und der zweiten Verzögerungszelle verbundenen ersten Mischer (MPA), der in der Lage ist, das erste Paar von verzögerten Signalen direkt oder indirekt mit dem zweiten Paar von verzögerten Signalen, das als Mischbefehl wirkt, zu mischen und ein erstes Paar von Differenzsignalen auszugeben, das den Quadraturfehler zwischen dem ersten verzögerten Signal und dem dritten verzögerten Signal repräsentiert,
einen mit den Ausgängen der ersten und der zweiten Verzögerungszelle verbundenen zweiten Mischer (MPB), der in der Lage ist, das zweite Paar von verzögerten Signalen direkt oder indirekt mit dem ersten Paar von verzögerten Signalen, das als Mischbefehl wirkt, zu mischen, und ein zweites Paar von Differenzsignalen auszugeben, das den Quadraturfehler zwischen dem ersten verzögerten Signal und dem dritten verzögerten Signal repräsentiert,
ein mit den zwei Ausgängen des ersten Mischers verbundenes erstes Tiefpaßfilter (FA), ein mit den zwei Ausgängen des zweiten Mischers verbundenes zweites Tiefpaßfilter (FB) und Additionseinrichtungen, die mit den Ausgängen der zwei Tiefpaßfilter verbunden sind,
und **dadurch**, daß einer der Ausgänge der Additionseinrichtungen mit dem Verzögerungssteuereingang einer der Verzögerungszellen verbunden ist, während der andere Ausgang der Additionseinrichtungen mit dem Verzögerungssteuereingang der anderen Verzögerungszelle verbunden ist, um durch Erhöhen des Werts der einen der zwei Verzögerungen und durch Verringern des Werts der anderen Verzögerung kontinuierlich den Wert der ersten Verzögerung und der zweiten Verzögerung anzupassen, bis unabhängig von dem Quadraturfehler die vier verzögerten Quasiquadratursignale erzielt sind.

9. Vorrichtung nach Anspruch 7 oder 8, **dadurch gekennzeichnet, daß** sie Signalformungseinrichtungen (MFA,MFB) aufweist, die zwischen den Eingängen der Mischer und den Ausgängen der Verzögerungszellen angeordnet sind.

10. Vorrichtung nach einem der Ansprüche 7 bis 9, **dadurch gekennzeichnet, daß** jede Verzögerungszelle (DLA,DLB) einen differentiellen Komparator variabler Ladung aufweist.

11. Vorrichtung nach einem der Ansprüche 7 bis 10, **dadurch gekennzeichnet, daß** jeder Mischer (MPA,MPB) ein passiver Ringmischer ist, der aus vier ringförmig angeordneten Transistoren gebildet ist.

12. Vorrichtung nach einem der Ansprüche 7 bis 11, **dadurch gekennzeichnet, daß** sie ein aktives differentielles Integrationsfilter (FI) mit Gleichtaktsteuerung (MCMC) aufweist, das zwischen den zwei Ausgängen des Addierers und den zwei Verzögerungssteuereingängen der zwei Verzögerungszellen angeordnet ist.

13. Vorrichtung nach Anspruch 12, **dadurch gekennzeichnet, daß** sie Isolierungseinrichtungen (BI) aufweist, die zwischen den Ausgängen des Integrationsfilters und den zwei Verzögerungssteuereingängen der zwei Verzögerungszellen angeordnet sind und in der Lage sind, das Integrationsfilter von dem Rauschen, das von den Verzögerungszellen erzeugt wird, zu isolieren.

14. Vorrichtung nach einem der Ansprüche 7 bis 13, **dadurch gekennzeichnet, daß** der Generator (LO) in der Lage ist, an seinem ersten Ausgang das erste Basissignal und ein drittes Basissignal zu erzeugen, das bezüglich des ersten Basissignal eine im wesentlichen entgegengesetzte Phase hat, und an seinem zweiten Ausgang das zweite Basissignal und ein viertes Basissignal zu erzeugen, das bezüglich des zweiten Basissignals eine im wesentlichen entgegengesetzte Phase hat.

15. Vorrichtung nach einem der Ansprüche 7 bis 14, **dadurch gekennzeichnet, daß** sie in Silizium integriert ist.

16. Empfänger für digitale Fernsehsignale über Satellit, **dadurch gekennzeichnet, daß** er eine Synthonisationsvorrichtung (TZIF) aufweist, die ein Vorrichtung nach einem der Ansprüche 7 bis 15 umfasst.

## Claims

1. Process for controlling the phase shift between four signals mutually phase quadrature, **characterized in that** at least a first base signal (S0) and a second base signal (S90) in quadrature with respect to the first base signal and which is liable to exhibit a quadrature error with respect to the first base signal are used to formulate a first pair of signals delayed by a first adjustable delay comprising a first signal (SR0) delayed with respect to the first base signal (S0) and a second delayed signal (SR180) in phase opposition with respect to the first delayed signal, and a second pair of signals delayed by a second adjustable delay comprising a third signal (SR90) delayed with respect to the second base signal and a fourth delayed signal (SR270) in phase opposition with respect to the third delayed signal, and the value of each of the delays is adjusted continuously using two differential signals (SIS2, SIS1) arising from direct or indirect cross-mixings of the two pairs of delayed signals so as to increase the value of one of the two delays and to decrease the value of the other delay such as to obtain the four delayed signals virtually in quadrature independently of the said quadrature error.

2. Process according to Claim 1, **characterized in that** in the adjustment step, the first pair of delayed signals (SR0, SR180) is mixed directly or indirectly with the second pair of delayed signals (SR90, SR270) acting in the guise of control of the mixing and the second pair of delayed signals (SR90, SR270) is mixed directly or indirectly with the first pair of delayed signals (SR0, SR180) acting in the guise of control of the mixing, so as to obtain a first pair of differential signals and a second pair of differential signals both of which are representative of the quadrature error between the first delayed signal (SR0) and the third delayed signal (SR90), low-pass filtering (FA, FB) is carried out and the two pairs of differential signals are summed so as to obtain a pair of summed filtered differential signals (SDFS1, SDFS2), and the value of the first delay is continuously adjusted using one of the two summed filtered differential signals whilst the value of the second delay is continuously adjusted using the other summed filtered differential signal so as to increase the value of one of the two delays and to decrease the value of the other delay such as to obtain the four delayed signals virtually in quadrature independently of the said quadrature error.

3. Process according to Claim 1 or 2,
**characterized in that** the delayed signals are shaped (MFA, MFB) before mixing.

4. Process according to one of the preceding claims, **characterized in that** an integration (FI) of the two summed filtered differential signals is performed, and the adjustment of the value of the delays is performed using these integrated differential signals (SI1, SI2).

5. Process according to Claim 4, **characterized in that** the integrating filter (FI) is isolated from the noise generated during the phase of delaying the base signals.

6. Process according to one of the preceding claims, **characterized in that** the pairs of delayed signals are formulated from the first base signal (S0), the second base signal (S90), a third base signal (S180) substantially in phase opposition with respect to the first base signal and a fourth base signal (S270) substantially in phase opposition with respect to the second base signal.

7. Device for controlling the phase shift between four signals mutually in phase quadrature, **characterized in that** it comprises a generator (LO) possessing a first output for generating at least a first base signal (S0) and a second output for generating at least a second base signal (S90) in quadrature with respect to the first base signal and liable to exhibit a quadrature error with respect to the first base signal and a differential phase lock loop (IQPLL) comprising
a first delay cell (DLA) connected to the first output of the generator and possessing a delay control input, able to deliver a first pair of signals delayed by a first adjustable delay comprising a first signal delayed with respect to the first base signal and a second delayed signal in phase opposition with respect to the first delayed signal,
a second delay cell (DLB) connected to the second output and possessing a delay control input, able to deliver a second pair of signals delayed by a second adjustable delay comprising a third signal delayed with respect to the second base signal and a fourth delayed signal in phase opposition with respect to the third delayed signal, and
differential means of adjustment connected between the outputs of the delay cells and their control inputs, and able to continuously adjust the value of each of the delays using two differential signals (SIS2, SIS1) arising from direct or indirect cross-mixings of the two pairs of delayed signals, so as to increase the value of one of the two delays and to decrease the value of the other delay such as to obtain the four delayed signals virtually in quadrature independently of the said quadrature error.

8. Device according to Claim 7, **characterized in that** the means of adjustment comprise
a first mixer (MPA), connected to the outputs of the first and of the second delay cell, able to directly or indirectly mix the first pair of delayed signals with the second pair of delayed signals acting in the guise of control of the mixing, and to deliver a first pair of differential signals representative of the quadrature error between the first delayed signal and the third delayed signal,
a second mixer (MPB), connected to the outputs of the first and of the second delay cell, able to directly or indirectly mix the second pair of delayed signals with the first pair of delayed signals acting in the guise of control of the mixing, and to deliver a second pair of differential signals representative of the quadrature error between the first delayed signal and the third delayed signal,
a first low-pass filter (FA) connected to the two outputs of the first mixer, a second low-pass filter (FB) connected to the two outputs of the second mixer, and summation means connected to the outputs of the two low-pass filters,
and **in that** one of the outputs of the summation means is linked to the delay control input of one of the delay cells, whilst the other output of the summation means is linked to the delay control input of the other delay cell, so as to continuously adjust the value of the first delay and of the second delay by increasing the value of one of the two delays and by decreasing the value of the other delay such as to obtain the four delayed signals virtually in quadrature independently of said quadrature error.

9. Device according to Claim 7 or 8, **characterized in that** it comprises signal shaping means (MFA, MFB) connected between the inputs of the mixers and the outputs of the delay cells.

10. Device according to one of Claims 7 to 9, **characterized in that** each delay cell (DLA, DLB) comprises a variable-load differential comparator.

11. Device according to one of Claims 7 to 10, **characterized in that** each mixer (MPA, MPB) is a ring-like passive mixer formed of four transistors mounted in a ring.

12. Device according to one of Claims 7 to 11, **characterized in that** it comprises an active differential integrating filter (FI) with common mode control (MCMC), connected between the two outputs of the summator and the two delay control inputs of the two delay cells.

13. Device according to Claim 12, **characterized in that** it comprises isolation means (BI) connected between the outputs of the integrating filter and the two delay control inputs of the two delay cells and able to isolate the integrating filter from the noise generated by the delay cells.

14. Device according to one of Claims 7 to 13, **characterized in that** the generator (LO) is able to generate on its first output the first base signal and a third base signal substantially in phase opposition with respect to the first base signal and to generate on its second output the second base signal and a fourth base signal substantially in phase opposition with respect to the second base signal.

15. Device according to one of Claims 7 to 14, **characterized in that** it is integrated on silicon.

16. Receiver of satellite digital television signals, **characterized in that** it comprises a tuning device (TZIF) incorporating a device according to one of Claims 7 to 15.
